# EUROPEAN PATENT SPECIFICATION

(11) **EP 3 693 659 B1**
(45) Date of publication and mention of the grant of the patent: **06.04.2022**
(21) Application number: 18864857.0
(22) Date of filing: 02.10.2018
(51) Int. Cl.: F21V 29/502, F21S 41/16, F21S 45/40, F21V 9/30, F21V 29/70, F21V 29/85, H01L 33/50, H01S 5/02, F21Y 115/30, F21Y 115/10, F21W 102/13

(54) **LIGHT SOURCE DEVICE AND ILLUMINATION DEVICE**
LICHTQUELLENVORRICHTUNG UND BELEUCHTUNGSVORRICHTUNG
DISPOSITIF DE SOURCE DE LUMIÈRE ET DISPOSITIF D'ÉCLAIRAGE

(30) Priority: 02.10.2017 JP 2017192506; 01.11.2017 JP 2017211588
(43) Date of publication of application: 12.08.2020
(73) Proprietor: Kyocera Corporation, Kyoto-shi Kyoto 612-8501 (JP)
(72) Inventor: KUBO, Yoshinori, Kyoto-shi Kyoto 612-8501 (JP)
(74) Representative: Viering, Jentschura & Partner mbB Patent- und Rechtsanwälte
(86) International application number: PCT/JP2018/036910
(87) International publication number: WO 2019/069937

(56) References cited:
- WO-A1-2017/043122
- WO-A1-2017/043180
- JP-A- H11 337 919
- JP-A- 2012 173 593
- JP-A- 2013 030 720
- JP-A- 2015 036 790
- JP-A- 2017 009 823
- JP-A- 2017 123 348
- US-A1- 2014 168 942
- US-A1- 2015 049 307
- US-A1- 2015 167 905
- US-A1- 2015 167 905

## Description

### TECHNICAL FIELD

The present disclosure relates to a light source device and an illumination device.

### BACKGROUND ART

In recent years, an illumination device using an LED or a semiconductor laser (LD) as a light source has begun to be used for applications such as a vehicle headlight. A light source device used in this illumination device is configured to convert a wavelength of excitation light emitted to a wavelength conversion material such as a phosphor, thereby directly or indirectly generating white light.

As this white light is emitted in a desired direction using a reflector or a lens, the illumination device generates a larger light quantity than a conventional illumination device.

The conversion efficiency of this wavelength conversion material is not 100%, and some of energy of the emitted excitation light becomes heat. Therefore, a holding plate that holds the wavelength conversion material is required to have heat dissipation performance in addition to a light-transmitting property.

Sapphire has high light transmittance and thermal conductivity, and is excellent as a material of the holding plate. For example, Patent Documents 1 and 2 describe a light source device and an illumination device including a laser light source, a phosphor, and a sapphire plate holding the phosphor, and describe an example in which the sapphire plate is irradiated with a laser beam vertically.

US 2015/167905 A1 discloses a device according to the preamble of claims 1 and 2.

### RELATED ART DOCUMENTS

### PATENT DOCUMENTS

Patent Document 1: Japanese Unexamined Patent Publication No. 2013-254690
Patent Document 2: WO 2017/038164 A
US 2015/167905 A1

### SUMMARY OF THE INVENTION

A light source device of the present disclosure includes: a sapphire plate having a first surface and a second surface which oppose each other; a wavelength conversion material located opposite the first surface of the sapphire plate; and a first excitation light source which emits first excitation light having directivity to the wavelength conversion material through the second surface. An angle between the first surface and the second surface, and a c-axis of sapphire is larger than 89° and smaller than 91°, and an angle between the c-axis and an optical axis of the first excitation light is 1° or larger.

A light source device of the present disclosure includes: a sapphire plate having a first surface and a second surface which oppose each other; a wavelength conversion material located opposite the first surface of the sapphire plate; and a first excitation light source which emits first excitation light having directivity to the wavelength conversion material through the second surface. An angle between the first surface and the second surface, and a c-axis of sapphire is smaller than 1°, and an angle between the c-axis and an optical axis of the first excitation light is 89° or smaller.

Further, an illumination device of the present disclosure includes the light source device and a light guide member.

### BRIEF DESCRIPTION OF THE DRAWINGS

Fig. 1 is a schematic cross-sectional view of a light source device according to first and second embodiments.
Fig. 2 is a schematic diagram showing crystal structures of sapphire.
Fig. 3 is a schematic diagram showing a positional shift between normal light and abnormal light.
Fig. 4 is a graph showing a relationship between an incident angle of excitation light with respect to a main surface of a sapphire plate, and a reflectance.
Fig. 5 is a schematic cross-sectional view of a light source device according to a first modification of Fig. 1.
Fig. 6 is a schematic cross-sectional view of a light source device according to a second modification of Fig. 1.
Fig. 7 is a schematic view of a light source device according to a third modification of Fig. 1 as viewed from above.
Fig. 8 is a schematic view of a light source device according to a fourth modification of Fig. 1 as viewed from above.
Fig. 9 is a schematic cross-sectional view of an illumination device of the present disclosure.

### EMBODIMENTS FOR CARRYING OUT THE INVENTION

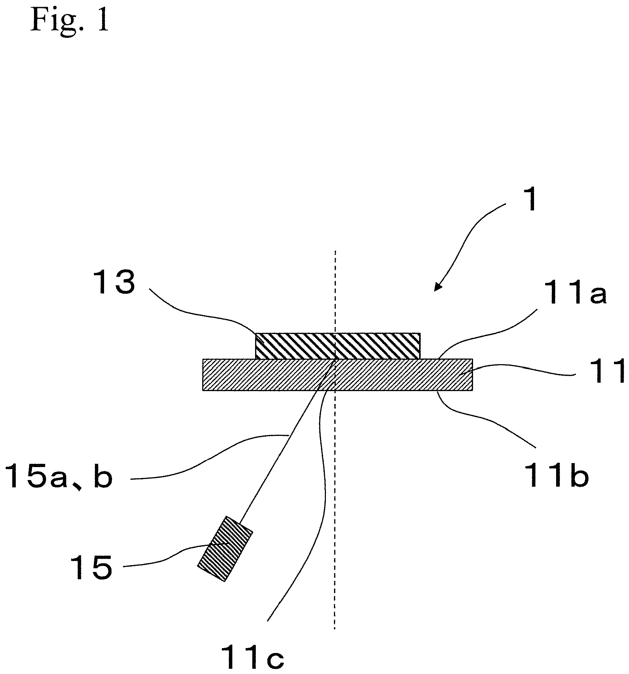

A light source device of the present disclosure and an illumination device using the same will be described with reference to the drawings. Fig. 1 is a schematic cross-sectional view of a light source device 1 according to first and second embodiments.

The light source device 1 of the present disclosure includes a sapphire plate 11 having a first surface 11a and a second surface 11b that oppose each other.

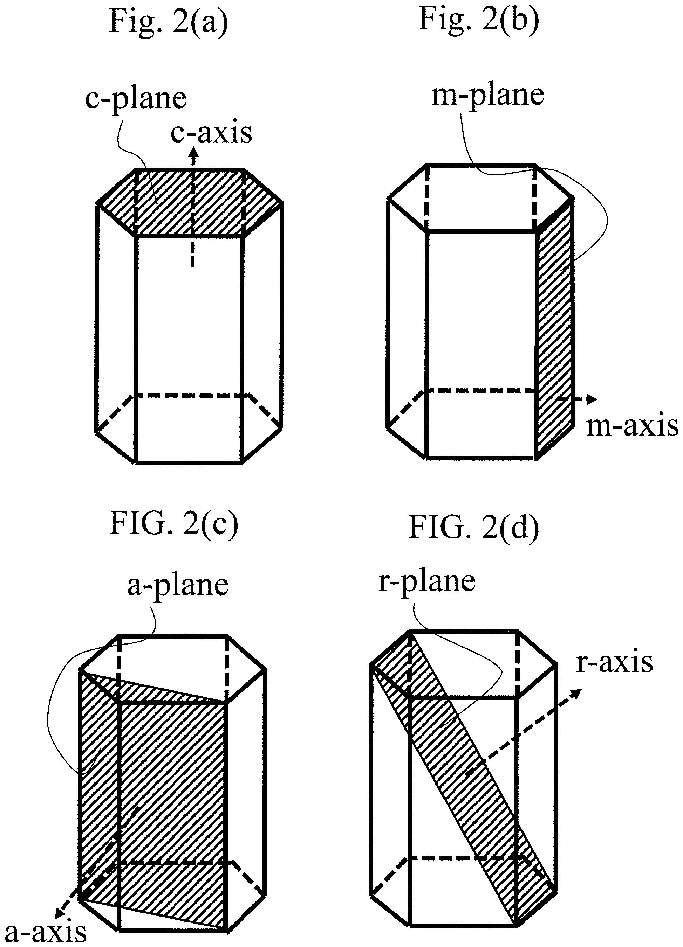

The sapphire refers to a single crystal of aluminum oxide (chemical formula: Al₂O₃). As shown in Figs. 2(a) to 2(d), sapphire has typical crystal planes such as a c-plane, an m-plane, an a-plane, and an r-plane. Axes perpendicular to these crystal planes are called a c-axis, an m-axis, an a-axis, and an r-axis, respectively.

The crystal orientation of the sapphire plate 11 can be specified using an X-ray diffractometer. For example, an automatic X-ray crystal orientation measuring device (model 2991F2) manufactured by Rigaku Corporation may be used as the X-ray diffractometer.

The light source device 1 of the present disclosure includes a wavelength conversion material 13 located opposite the first surface 11a of the sapphire plate 11. The light source device 1 of the present disclosure includes a first excitation light source 15 that emits first excitation light 15a having directivity. The first excitation light 15a is irradiated to the wavelength conversion material 13 through the second surface of the sapphire plate 11.

The wavelength conversion material 13 converts the wavelength of the irradiated first excitation light 15a to, for example, white light to obtain light for illumination.

In the sapphire plate 11 of the light source device 1 of the present disclosure, an angle formed by the first surface 11a and the second surface 11b, and the c-axis of sapphire is larger than 89° and smaller than 91°. In other words, the inclination of the first surface 11a and the second surface 11b of the sapphire plate 11 from the c-plane of sapphire is smaller than 1°.

When the first excitation light 15a passes through the sapphire plate 11 and is irradiated to the wavelength conversion material 13, temperatures of the wavelength conversion material 13 and the sapphire plate 11 increase due to some of energy of the first excitation light 15a.

Since the sapphire plate 11 has a plate shape, a length in the plane direction is longer than a length in the thickness direction. Therefore, a dimensional change in the plane direction is larger than a dimensional change in the thickness direction. Therefore, assuming the same thermal expansion coefficient in the plane direction, it is possible to suppress peeling of the wavelength conversion material 13 from the sapphire plate 11 and damage to the wavelength conversion material 13 caused by a difference in thermal expansion in the plane direction.

A thermal expansion coefficient of sapphire from 40°C to 400°C is 7.7 × 10⁻⁶/°C in a direction parallel to the c-axis of sapphire and is 7.0 × 10⁻⁶/°C in a direction perpendicular to the c-axis . In this manner, the sapphire is a material having anisotropy in thermal expansion coefficient.

Since sapphire has the same thermal expansion coefficient in any direction perpendicular to the c-axis, and thus, it is possible to decrease the difference in thermal expansion coefficient generated in the plane direction if the angle between the first surface 11a and the second surface 11b of the sapphire plate 11, and the c-axis of sapphire is within the range of being larger than 89° and smaller than 91° (the first embodiment).

Since sapphire has the same thermal expansion coefficient in any direction parallel to the c-axis, and thus, it is possible to decrease the difference in thermal expansion coefficient generated in the plane direction if the angle between the first surface 11a and the second surface 11b of the sapphire plate 11, and the c-axis of sapphire is within the range of being smaller than 1° (the second embodiment).

Since the sapphire has anisotropy in mechanical strength, the sapphire plate 11 has large deflective strength, when the main surfaces 11a and 11b of the sapphire plate 11 are parallel to the c-axis. In particular, the a-plane shows the highest strength. It is preferable to make the main surfaces 11a and 11b of the sapphire plate 11 parallel to the c-axis in order to suppress breakage of the sapphire plate 11 and make the light source device 1 hard to break. Here, "parallel" means to have an angle of 1° or smaller (the second embodiment).

Since the deflective strength of sapphire is maximized in the c-axis direction of the a-plane, it is preferable to set the a-plane as the main surface of the sapphire plate 11 and the c-axis direction as the long-axis direction when the sapphire plate 11 has a shape with a long-axis (long-side) direction and a short-axis (short-side) direction, for example, a rectangular plate shape. Further, since the anisotropy of the deflective strength is small in the plane direction when the m-plane is set as the main surface, it is preferable to set the m-plane as the main surface of the disc-shaped sapphire plate 11 (the second embodiment).

In the light source device 1 of the present disclosure, an angle between a c-axis 11c of the sapphire plate 11 and an optical axis 15b of the first excitation light 15a is 1° or larger. In other words, as shown in Fig. 1, the first excitation light 15a is obliquely incident on the second surface 11b of the sapphire plate 11 (the first embodiment).

Further, in light source device 1 of the present disclosure, the angle between the c-axis 11c of the sapphire plate 11 and the optical axis 15b of the first excitation light 15a is 89° or smaller. In other words, as shown in Fig. 1, the first excitation light 15a is obliquely incident on the second surface 11b of the sapphire plate 11 (the second embodiment) .

The sapphire is a birefringent crystal. Birefringence means that a light beam is divided into normal light and abnormal light depending on a polarization state at the time of passing through a substance. Refractive indices of the two types of light coincide when the light travels coaxially with the optical axis (c-axis) 11c of the sapphire plate 11, and the light is not divided into two. On the other hand, when the traveling direction of light is not coaxial with the optical axis 11c of the sapphire plate 11, a refractive index of normal light does not depend on an angle of the light with respect to the optical axis, but a refractive index of abnormal light changes depending on the angle of the light with respect to the optical axis 11c.

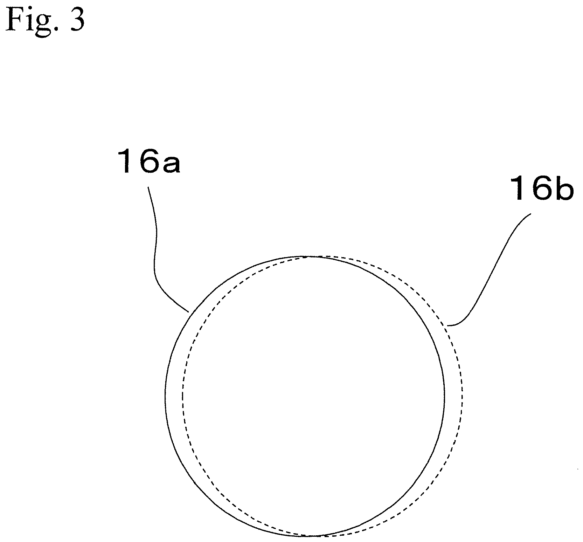

For example, when a cross-sectional shape of the first excitation light 15a perpendicular to the optical axis 15b is circular and the first excitation light 15a is not coaxial with the optical axis 11c of the sapphire plate 11, the first excitation light 15a is divided into normal light 16a indicated by the solid line and abnormal light 16b indicated by the broken line while the first excitation light 15a having the circular cross section perpendicular to the optical axis 15b passes through the sapphire plate 11, so that two circles are superimposed to form an approximately elliptical shape as shown in Fig. 3.

At this time, a light quantity is larger in a region including both the normal light 16a and the abnormal light 16b than in a region including only the normal light 16a and a region including only the abnormal light 16b. Therefore, the region with the smaller light quantity is arranged outside the region with the larger light quantity. Further, a region that is not irradiated with the first excitation light 15a is present outside the region with the smaller light quantity.

As the light quantity increases, a heat value of the wavelength conversion material 13 increases, and thus, a region with a smaller heat value is arranged outside a region with a larger heat value in the light source device 1 of the present disclosure. Further, a region that is not irradiated with the first excitation light 15a and does not generate heat is present on the outer side thereof.

The region that is not irradiated with light becomes a region that transmits and radiates the heat generated by the irradiation of light, so that there is a temperature difference between a region shone by light and a region outside the region. As the temperature difference becomes steeper, the strain generated due to the thermal expansion increases in the wavelength conversion material 13 or the sapphire plate 11.

In the light source device 1 of the present disclosure, the first excitation light 15a is divided into the normal light 16a and the abnormal light 16b by utilizing the property of birefringence of the sapphire plate 11, and the region with the smaller heat value is arranged outside the region with the larger heat value, so that the temperature difference generated in the wavelength conversion material 13 and the sapphire plate 11 can be made relatively gentle, and it is possible to suppress the wavelength conversion material 13 from being peeled off the sapphire plate 11.

A positional shift between the normal light 16a and the abnormal light 16b obtained by utilizing the birefringence changes depending on the angle between the optical axis 15b of the first excitation light 15a and the c-axis 11c of the sapphire plate 11, and the incident angle. The light incident on the second surface 11b of the sapphire plate 11 at an incident angle θa from air is refracted at an interface between the air and the sapphire plate 11 (the second surface 11b) to propagate through the sapphire plate 11 at a refraction angle 9b. When a refractive index of the sapphire plate 11 is N, sin θa/sin θb = N according to Snell's law. Using this relationship, it is possible to calculate a positional shift between the normal light 16a and the abnormal light 16b.

### (First Embodiment)

For example, when the first excitation light 15a having a wavelength of 488 nm (the refractive index of the normal light is 1.775 and the refractive index of the abnormal light is 1.767 to 1.775) is incident on the second surface 11b of the sapphire plate 11 having the c-plane whose thickness is 3.0 mm as the main surface, a positional shift on the first surface 11a generated by a difference in the refractive index between the normal light 16a and the abnormal light 16b is 0.3 µm, 2.0 µm, and 5.0 µm if the incident angle θa is 20°, 40°, and 60°, respectively. Therefore, the angle between the c-axis 11c and the optical axis 15b of the first excitation light 15a may be 20° or larger, and more preferably 40° or larger.

### (Second Embodiment)

For example, when the first excitation light 15a having a wavelength of 488 nm (the refractive index of the normal light is 1.775 and the refractive index of the abnormal light is 1.767 to 1.775) is incident on the second surface 11b of the sapphire plate 11 having the a-plane whose thickness is 3.0 mm as the main surface with an incident plane that is parallel to the c-axis (having the angle of 0° with respect to the c-axis) as illustrated in Fig.1, a positional shift on the first surface 11a generated by the difference in the refractive index between the normal light 16a and the abnormal light 16b is 0 when the incident angle θa is 0° and 90°, and is 2.3 µm, 2.9 µm, and 1.6 µm if the incident angle θa is 20°, 40°, and 60°, respectively.

Further, when the first excitation light 15a having the wavelength of 488 nm is incident with an incident plane perpendicular to the c-axis (having an angle of 90° with respect to the c-axis), a positional shift of the first surface 11a generated by the difference in the refractive index between the normal light 16a and the abnormal light 16b increases as the incident angle θa increases, and is 2.6 µm, 4.9 µm, and 6.6 µm if the incident angle θa is 20°, 40°, and 60°, respectively.

Therefore, the angle between the c-axis 11c and the optical axis 15b of the first excitation light 15a may be 20° or larger, and more preferably 40° or larger. As described above, the magnitude of the birefringence increases as the angle between the incident plane of the first excitation light 15a and the c-axis 11c, that is, an angle between a projection line of the optical axis 15b of the first excitation light 15a onto the second main surface 11b, and the c-axis 11c increases. Thus, it is more preferable to set the angle between the incident plane of the first excitation light 15a and the c-axis 11c, that is, the angle between the projection line of the optical axis 15b of the first excitation light 15a onto the second main surface 11b, and the c-axis 11c to be 20° or larger.

Further, the incident angle of the first excitation light 15a with respect to the second main surface 11b may be 75° or smaller. Note that the incident angle is 0° when the first excitation light 15a is incident to be perpendicular to the second main surface 11b.

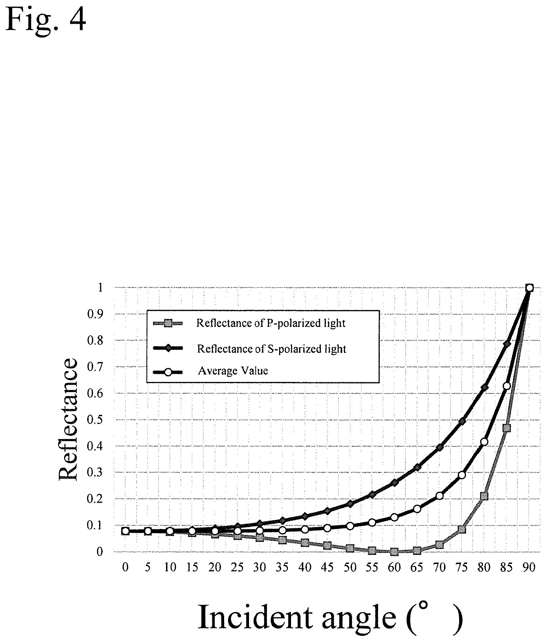

As shown in Fig. 4, a ratio of the first excitation light 15a reflected by the second main surface 11b changes depending on the incident angle of the first excitation light 15a with respect to the second main surface 11b. The reflected portion of the first excitation light 15a does not contribute to light emission. Therefore, the light emission efficiency decreases if a reflectance increases, so that it is required to reduce the reflection.

A graph in Fig. 4 is obtained by calculating a relationship between the incident angle of the first excitation light 15a having the wavelength of 488 nm with respect to the second main surface 11b and the reflectance when the surface of the sapphire plate 11 is a mirror surface. Note that a difference between the refractive indices of the normal light 16a and the abnormal light 16b is small. Therefore, this graph is calculated using only the refractive index of the normal light 16a, and the abnormal light 16b is overlooked.

The graph shows a reflectance of P-polarized light and a reflectance of S-polarized light, and an average value of the reflectance of P-polarized light and the reflectance of S-polarized light. If the first excitation light 15a is natural light that is not polarized, the relationship between the incident angle of the first excitation light 15a to the second main surface 11b and the reflectance is represented by the average value of the reflectance of the P-polarized light and the reflectance of the S-polarized light.

The reflectance is relatively small in a region where the incident angle of the first excitation light 15a with respect to the second main surface 11b is 75° or smaller. Therefore, if the incident angle of the first excitation light 15a with respect to the second main surface 11b is set to 75° or smaller, the reflection of the first excitation light 15a on the second main surface 11b can be suppressed, and the light emission efficiency can be increased. When the incident angle of the first excitation light 15a with respect to the second main surface 11b is set to 55° or smaller, the reflectance can be further decreased.

(First Embodiment) Considering the positional shift between the normal light 16a and the abnormal light 16b and the reflection of the first excitation light 15a on the second main surface 11b, it is preferable to set the incident angle of the first excitation light 15a with respect to the second main surface 11b within a range of 40 to 55°.

(Second Embodiment) Considering the positional shift between the normal light 16a and the abnormal light 16b and the reflection of the first excitation light 15a on the second main surface 11b, it is preferable to set the incident angle of the first excitation light 15a with respect to the second main surface 11b within a range of 20 to 55°.

In the light source device 1 of the present disclosure, the irradiation is performed such that the optical axis 15b of the first excitation light 15a is oblique to the second main surface 11b of the sapphire plate 11. Therefore, even if the first excitation light 15a is reflected by the second main surface 11b, the reflected light can be prevented from being emitted to the first excitation light source 15, and thus, it is possible to suppress the damage of the first excitation light source 15.

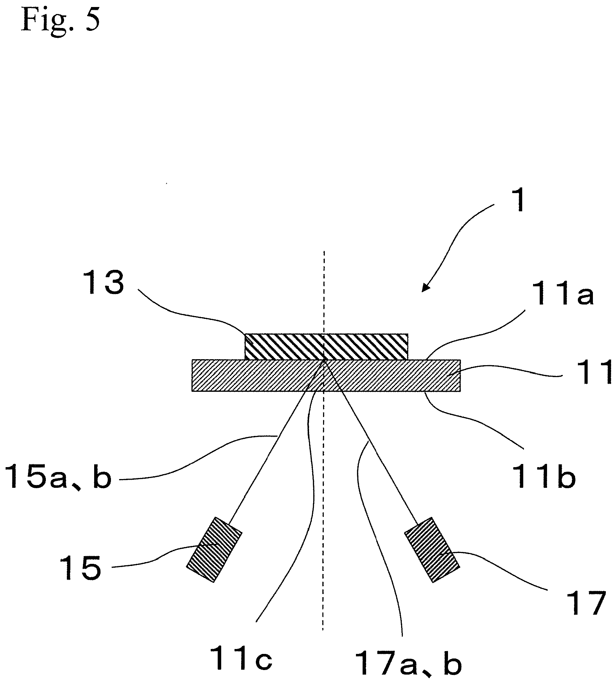

As in a first modification shown in Fig. 5, a second excitation light source 17 that irradiates the wavelength conversion material 13 with second excitation light 17a having directivity through the second surface 11b of the sapphire plate 11 may be further provided. When the plurality of excitation light sources 15 and 17 are provided as described above, the light quantity of the light source device 1 can be increased. Further, a desired light quantity can be obtained even when the first and second excitation light sources 15 and 17 having relatively small light quantities are combined.

The second excitation light 17a may be arranged so as to at least partially overlap with the first excitation light 15a on the wavelength conversion material 13. When the beams of the excitation light overlap with each other, the area of the wavelength conversion material 13 can be decreased. When the area of the wavelength conversion material 13 can be decreased, the area where the wavelength conversion material 13 and the sapphire plate 11 are in contact decreases. If thermal expansion coefficients of both the wavelength conversion material 13 and the sapphire plate 11 are different, the stress caused by a difference in thermal expansion decreases as the contact area therebetween decreases, and it is possible to suppress the wavelength conversion material 13 from being peeled off from the sapphire plate 11.

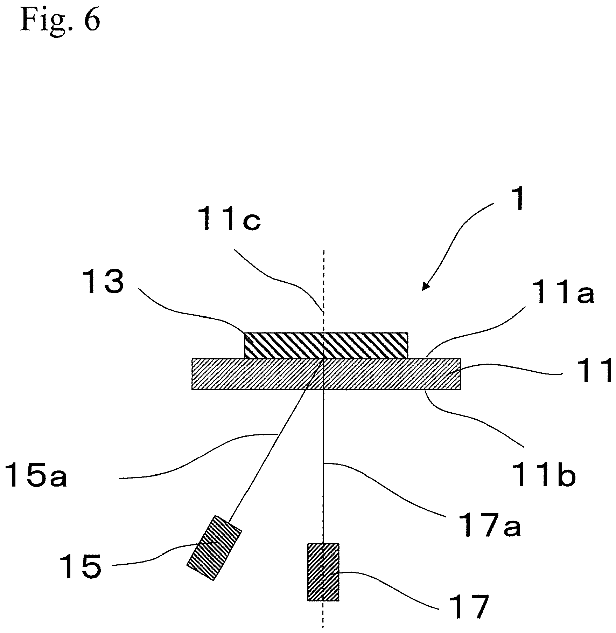

When the light source device 1 includes the plurality of excitation light sources 15 and 17, an angle between the c-axis 11c and the optical axis 15b of the first excitation light 15a, and an angle between the c-axis 11c and an optical axis 17b of the second excitation light 17a may be the same as shown in Fig. 5 or may be different as in a second modification shown in Fig. 6.

When the angle between the c-axis 11c and the optical axis 15b of the first excitation light 15a is different from the angle between the c-axis 11c and the optical axis 17b of the second excitation light 17a, it is possible to change sizes of a region irradiated with only normal light and a region irradiated with only abnormal light between the first excitation light 15a and the second excitation light 17a, and thus, the distribution of light quantities can be appropriately designed by combining these.

(First Embodiment) Note that an angle between the optical axis 17b of the second excitation light 17a and the c-axis may be 0°, if the angle between the optical axis 15b of the first excitation light 15a and the c-axis 11c is 1° or larger as shown in Fig. 6.

(Second Embodiment) The angle between the optical axis 17b of the second excitation light 17a and the c-axis may be 90°, if the angle between the optical axis 15b of the first excitation light 15a and the c-axis 11c is 89° or smaller as shown in Fig. 6.

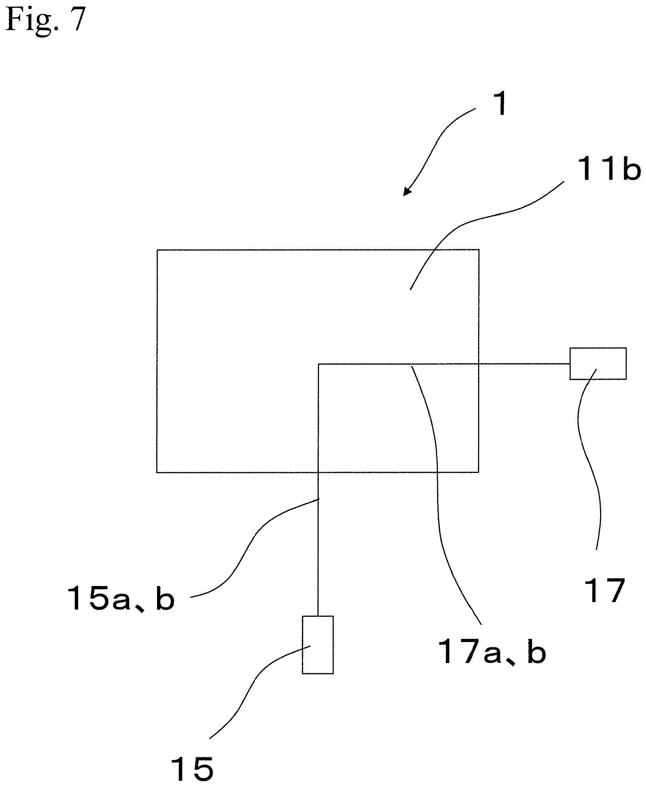

When viewed from the direction perpendicular to the second surface 11b of the sapphire plate 11, an angle between the optical axis 15b of the first excitation light 15a and the optical axis 17b of the second excitation light 17a may be in a range of 1° or larger and 179° or smaller. For example, when the angle between the optical axis 15b of the first excitation light 15a and the optical axis 17b of the second excitation light 17a is set to 90° in a range of 80° to 100° such that the first excitation light 15a and the second excitation light 17a overlap on the wavelength conversion material 13 as in a third modification shown in Fig. 7, the region irradiated with only the normal light and the region irradiated with only the abnormal light can be arranged both in the horizontal direction and the vertical direction, and thus, a temperature difference can be made gentle.

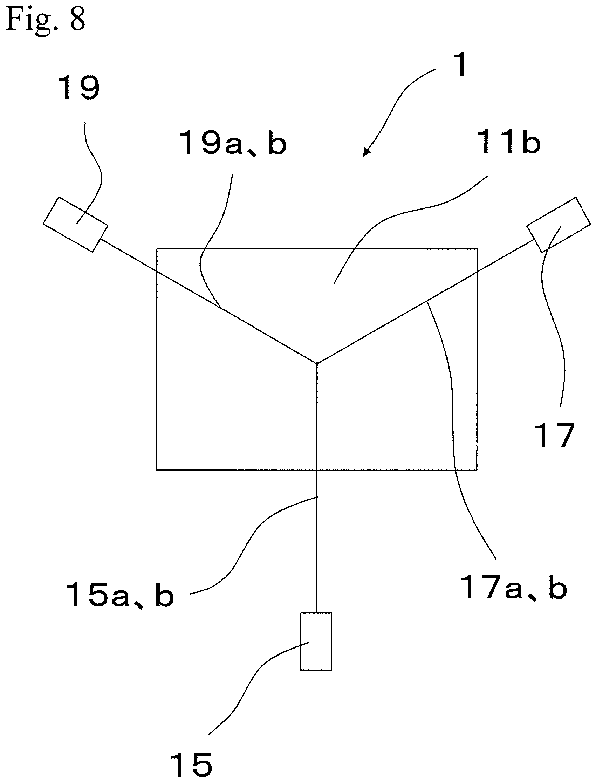

The light source device 1 of the present disclosure may further include a third excitation light source 19 that emits third excitation light 19a having directivity as in a fourth modification example shown in Fig. 8. With such a configuration, the light quantity of the light source device 1 can be further increased. Further, when viewed from the direction perpendicular to the second surface 11b, angles of the respective optical axes 15b, 17b, and 19b of the first excitation light 15a, the second excitation light 17a, and the third excitation light 19a with respect to the second surface 11b, formed when each excitation light is projected on the second surface 11b, may be the same and set to be 120°. With such a configuration, angles among the optical axes of the excitation light 15a, 17a, and 19a emitted to the wavelength conversion material 13 can be made equal intervals, and the distribution of the temperature difference can have regularity.

In the light source device 1, the optical axis 15b of the first excitation light 15a and the optical axis 17b of the second excitation light 17a may be arranged in asymmetric directions with respect to the irradiation position on the second surface 11b of the sapphire plate 11. That is, the plurality of excitation light sources 15 and 17 may be arranged such that one total reflection light is not emitted to the other. As a result, even if being reflected by the sapphire plate 11, the excitation light 15a and the excitation light 17a can be prevented from being emitted to the other excitation light sources 15 and 17 and damaging the excitation light sources 15 and 17, respectively.

In the light source device 1 of the present disclosure, the excitation light sources 15, 17, and 19 may be laser light sources . Since a laser beam emitted from the laser light source has high directivity and high output, the output of the light source device 1 can be increased. Further, the excitation light sources 15, 17, and 19 may be LEDs, and the excitation light may be guided using a deformable optical fiber. With such a configuration, the degree of freedom in designing the light source device 1 increases. Further, in any case, a heat source can be separated by increasing a distance between the wavelength conversion material 13, which is a heat-generating source, and each of the excitation light sources 15, 17, and 19, thereby facilitating heat dissipation.

If a thickness of the sapphire plate 11 is 0.2 mm or more, it is possible to provide sufficient mechanical strength as a holding member of the wavelength conversion material 13. In particular, if the thickness of the sapphire plate 11 is 1 mm or more, deformation and breakage due to local heat generation caused by laser beam irradiation hardly occur. Further, if the thickness of the sapphire plate 11 is set in a range of 2 mm or more and 4 mm or less, the heat dissipation property can be increased. Further, the positional shift between the normal light 16a and the abnormal light 16b increases as the thickness of the sapphire plate 11 increases. Therefore, if the thickness of the sapphire plate 11 is 2 mm or more, the positional shift between the normal light 16a and the abnormal light 16b emitted to the wavelength conversion material 13 can be set to be relatively large.

An angle between an axis perpendicular to the main surface (first surface 11a and second surface 11b) of the sapphire plate 11 and the c-axis 11c of sapphire plate 11 may be set to 0.1° or larger. In other words, the first surface 11a and the second surface 11b of the sapphire plate 11 may have an offset angle of 0.1° or larger from the c-plane.

(First Embodiment) When the first surface 11a and the second surface 11b of the sapphire plate 11 have the offset angle of 0.1° or larger from the c-plane, a step structure having a height of several Å and a width of several tens to several hundreds of Å is formed on the first surface 11a and the second surface 11b of the sapphire plate 11. As the offset angle is larger, the step has a larger height and a smaller width. The offset angle may be set to 0.5° or larger in order to make the step structure large.

(Second Embodiment) When the first surface 11a and the second surface 11b of the sapphire plate 11 have an offset angle of 0.1° or larger from a plane perpendicular to the c-plane, a step structure having a height of several Å and a width of several tens to several hundreds of Å is formed on the first surface 11a and the second surface 11b of the sapphire plate 11. As the offset angle is larger, the step has a larger height and a smaller width. The offset angle may be set to 0.5° or larger in order to make the step structure large.

With such a configuration, a relatively large step structure is formed on the first surface 11a and the second surface 11b of the sapphire plate 11.

When the first surface 11a and the second surface 11b of the sapphire plate 11 have such a step structure, in a process of forming an antireflection film, a dichroic film, and a wavelength conversion material 13, which will be described later, these films are likely to be adsorbed to the step portion. Therefore, a uniform film can be formed on the sapphire plate 11, the adhesion between the sapphire plate 11 and the films is improved due to the anchor effect, and it is possible to prevent peeling of these films as the sapphire plate 11 is repeatedly heated and cooled.

When the first excitation light 15a has, for example, a blue wavelength of about 460nm, the step structure is sufficiently smaller than the wavelength, and thus, the influence on optical characteristics of the light source device 1 is suppressed to a level that is hardly perceived.

As a heat treatment or a plasma treatment is performed as a pretreatment for formation of the film on the surfaces of the first surface 11a and the second surface 11b of the sapphire plate 11, a step structure having more uniform steps is easily generated on the main surfaces 11a and 11b. With such a step structure, the adhesion strength between the sapphire plate 11 and the film is high, and a variation in the adhesion strength is small. For example, as the pretreatment, the sapphire plate 11 may be subjected to a heat treatment at a temperature of 800°C or higher, for example, 1000°C, for about 3 hours.

The first excitation light 15a may be condensed to a diameter of about 0.5 mm or more and 3 mm or less and irradiated on the wavelength conversion material 13. When the light density of the first excitation light 15a incident on the wavelength conversion material 13 is increased in this manner, the light source device 1 having a small size and high luminance can be obtained. Further, an illumination device with excellent design can be provided.

The light source device 1 may include the dichroic film (not shown), which transmits the first excitation light 15a and reflects wavelength-converted light, between the sapphire plate 11 and the wavelength conversion material 13. Further, the antireflection film (not shown), which reduces the reflectance of the first excitation light 15a, may be provided on the second surface 11b of the sapphire plate 11. The dichroic film and the antireflection film can enhance the light emission efficiency of the light source device 1.

The sapphire plate 11 and the wavelength conversion material 13 may be in direct contact, or may be in indirect contact with the dichroic film or the like interposed therebetween.

The wavelength conversion material 13 is, for example, a phosphor. In particular, the wavelength conversion material 13 may be a ceramic phosphor. With such a configuration, the light source device 1 has the excellent heat resistance.

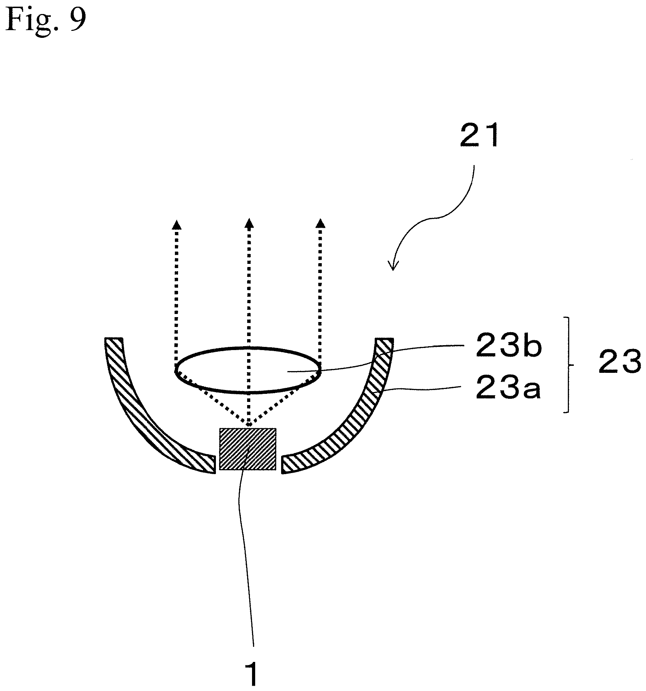

As shown in Fig. 9, an illumination device 21 of the present disclosure includes a reflector 23a and a lens 23b, which are light guide members 23 that guide light, emitted by the light source device 1 of the present disclosure, in a desired direction. Note that the light source device 1 is described in a simplified manner in Fig. 9. The illumination device 21 of the present disclosure is suitable for a spotlight, a headlight for a mobile body such as a vehicle, and the like. Among vehicle headlights, particularly a traveling headlight (so-called high beam) is required to have performance capable of confirming a traffic obstacle at a distance of 100 m ahead of the vehicle at night. The light source device 1 and the illumination device 21 of the present disclosure can suppress the deterioration of the wavelength conversion material 13 even when having a high light quantity with an irradiation distance of 100 m or more, for example, 600 m.

Further, the light source device 1 may be designed such that the sapphire plate 11 is cooled by airflow. For the cooling by airflow, a blower such as a fan to cool the sapphire plate 11 by air may be used. Further, the airflow generated with movement of a moving body such as a vehicle may be used. Further, a cooling fin may be connected to the sapphire plate 11 in order to improve the cooling effect. It is preferable to form the cooling fin on at least a part of a portion of the sapphire plate 11 other than the range irradiated with light.

Further, when one that attenuates light in a predetermined wavelength region such as ultraviolet light out of the irradiated light is used as the sapphire plate 11, it is possible to suppress damage of components of the light source device 1, such as the first excitation light source 15, caused by external light. For example, an average value of the transmittance of the sapphire plate 11 in a wavelength region of 200 to 400 nm may be smaller than an average value of the transmittance in a wavelength region of 400 to 800 nm. When the sapphire plate 11 satisfies such a configuration, the light in a so-called ultraviolet light region can be attenuated, and it is possible to suppress damage to the first excitation light source 15 and the like caused by ultraviolet light contained in sunlight that has entered the light source device 1.

Further, the sapphire plate 11 may have an absorption band in a wavelength region of 205 to 260 nm. When defects caused by oxygen vacancies are introduced into sapphire by controlling the atmosphere during sapphire crystal growth or during heat treatment after the growth to the reducing atmosphere, it is possible to produce sapphire having an absorption band in an ultraviolet region and capable of reducing ultraviolet light. The sapphire having the defects caused by oxygen vacancies has defects called an F center and an F+ center. The F center has an absorption band at 205 nm, and the F+ center has an absorption band at 210 nm, 230 nm, and 260 nm. When the sapphire plate 11 having such an absorption band in the wavelength region of 205 nm to 260 nm is used, the ultraviolet light that enters the light source device 1 can be attenuated.

As described above, the light source device 1 of the present disclosure is suitable for the illumination device 21 for a mobile object that is often exposed to external light such as sunlight. The moving body is, for example, a vehicle, and includes a ship, an airplane, and the like.

In such a light source device, the heat value of the wavelength conversion material is increased even if the light quantity is increased, so that it is possible to suppress the deterioration of the wavelength conversion material caused by heat. Further, it is possible to suppress the wavelength conversion material from being damaged by the stress caused by a temperature difference between a heat generating portion and a region outside the heat generating portion, and thus, it is possible to provide the light source device and the illumination device in which the performance deterioration and damage caused by heat hardly occur.

As described above, the embodiments of the light source device and the illumination device using the same have been described, but the present disclosure is not limited to the above embodiments, and various improvements and modifications may be made within the scope described in the claims.

### DESCRIPTION OF THE REFERENCE NUMERAL

- 1:: Light source device
- 11:: Sapphire plate
- 11a:: First surface
- 11b:: Second surface
- 11c:: c-axis
- 13:: Wavelength conversion material
- 15:: First excitation light source
- 15a:: First excitation light
- 15b:: Optical axis of first excitation light
- 16a:: Normal light
- 16b:: Abnormal light
- 17:: Second excitation light source
- 17a:: Second excitation light
- 17b:: Optical axis of second excitation light
- 19:: Third excitation light source
- 19a:: Third excitation light
- 19b:: Optical axis of third excitation light
- 21:: Illumination device
- 23:: Light guide member
- 23a:: Reflector
- 23b:: Lens

## Claims

1. A light source device (1) comprising:
a sapphire plate (11) having a first surface (11a) and a second surface (11b) which oppose each other;
a wavelength conversion material (13) located opposite to the first surface (11a) of the sapphire plate (11); and
a first excitation light source (15) which emits first excitation light (15a) having directivity to the wavelength conversion material (13) through the second surface (11b),
**characterized in that** an angle between the first surface (11a) and the second surface (11b), and a c-axis (11c) of sapphire is larger than 89° and smaller than 91°, and
an angle between the c-axis (11c) and an optical axis of the first excitation light (15b) is 1° or larger.

2. A light source device (1) comprising:
a sapphire plate (11) having a first surface (11a) and a second surface (11b) which oppose each other;
a wavelength conversion material (13) located opposite to the first surface (11a) of the sapphire plate (11); and
a first excitation light source (15) which emits first excitation light (15a) having directivity to the wavelength conversion material (13) through the second surface (11b),
**characterized in that** an angle between the first surface (11a) and the second surface (11b), and a c-axis (11c) of sapphire is smaller than 1°, and
an angle between the c-axis (11c) and an optical axis of the first excitation light (15b) is 89° or smaller.

3. The light source device (1) according to claim 1 or 2, wherein
the angle between the c-axis (11c) and the optical axis of the first excitation light (15b) is 20° or larger.

4. The light source device (1) according to any one of claims 1 to 3, wherein
an incident angle of the first excitation light (15a) with respect to the second main surface (11b) is 75° or smaller.

5. The light source device (1) according to any one of claims 1 to 4, further comprising
a second excitation light source (17) which emits second excitation light (17a) having directivity to the wavelength conversion material (13) through the second surface (11b),
wherein the first excitation light (15a) and the second excitation light (17a) at least partially overlap on the wavelength conversion material (13).

6. The light source device (1) according to claim 5, wherein
the angle between the c-axis (11c) and the optical axis of the first excitation light (15b) is different from an angle between the c-axis (11c) and an optical axis of the second excitation light (17b).

7. The light source device (1) according to claim 5 or 6, wherein
an angle between the optical axis of the first excitation light (15b) and the optical axis of the second excitation light (17b) is 80° or larger and 100° or smaller when viewed from a direction perpendicular to the second surface (11b).

8. The light source device (1) according to any one of claims 1 to 7, further comprising
a dichroic film, which transmits the excitation light (15a, 17a, 19a), and reflects wavelength-converted light emitted from the wavelength conversion material (13), is provided between the sapphire plate (11) and the wavelength conversion material (13).

9. The light source device (1) according to any one of claims 1 to 8, further comprising
an antireflection film, which reduces a reflectance of the excitation light (15a, 17a, 19a), is provided on the second surface (11b) of the sapphire plate (11).

10. An illumination device (21) comprising:
the light source device (1) according to any one of claims 1 to 9; and
a light guide member (23).

11. The light source device (1) according to claim 1, wherein
the first surface (11a) and the second surface (11b) of the sapphire plate (11) have an offset angle of 0.1° or larger from a c-plane.

12. The light source device (1) according to claim 2, wherein
the first surface (11a) and the second surface (11b) of the sapphire plate (11) have an offset angle of 0.1° or larger from a plane perpendicular to a c-plane.

## Patentansprüche

1. Lichtquellenvorrichtung (1), aufweisend:
eine Saphirplatte (11), die eine erste Fläche (11a) und eine zweite Fläche (11b) aufweist, die zueinander entgegengesetzt sind,
ein Wellenlängenumwandlungsmaterial (13), das gegenüber der ersten Fläche (11a) der Saphirplatte (11) angeordnet ist, und
eine erste Anregungslichtquelle (15), die erstes Anregungslicht (15a) mit einer Richtwirkung auf das Wellenlängenumwandlungsmaterial (13) durch die zweite Fläche (11b) hindurch emittiert,
**dadurch gekennzeichnet, dass** ein Winkel zwischen der ersten Fläche (11a) und der zweiten Fläche (11b) und einer c-Achse (11c) des Saphirs größer als 89° und kleiner als 91° ist, und
ein Winkel zwischen der c-Achse (11c) und einer optischen Achse des ersten Anregungslichts (15b) 1° oder größer ist.

2. Lichtquellenvorrichtung (1), aufweisend:
eine Saphirplatte (11), die eine erste Fläche (11a) und eine zweite Fläche (11b) aufweist, die zueinander entgegengesetzt sind,
ein Wellenlängenumwandlungsmaterial (13), das gegenüber der ersten Fläche (11a) der Saphirplatte (11) angeordnet ist, und
eine erste Anregungslichtquelle (15), die ein erstes Anregungslicht (15a) mit einer Richtwirkung auf das Wellenlängenumwandlungsmaterial (13) durch die zweite Fläche (11b) hindurch emittiert,
**dadurch gekennzeichnet, dass** ein Winkel zwischen der ersten Fläche (11a) und der zweiten Fläche (11b) und einer c-Achse (11c) des Saphirs kleiner als 1° ist, und
ein Winkel zwischen der c-Achse (11c) und einer optischen Achse des ersten Anregungslichts (15b) 89° oder kleiner ist.

3. Lichtquellenvorrichtung (1) gemäß Anspruch 1 oder 2, wobei
der Winkel zwischen der c-Achse (11c) und der optischen Achse des ersten Anregungslichts (15b) 20° oder größer ist.

4. Lichtquellenvorrichtung (1) gemäß irgendeinem der Ansprüche 1 bis 3, wobei
ein Einfallswinkel des ersten Anregungslichts (15a) in Bezug auf die zweite Hauptfläche (11b) 75° oder kleiner ist.

5. Lichtquellenvorrichtung (1) gemäß irgendeinem der Ansprüche 1 bis 4, ferner aufweisend
eine zweite Anregungslichtquelle (17), die zweites Anregungslicht (17a) mit einer Richtwirkung auf das Wellenlängenumwandlungsmaterial (13) durch die zweite Fläche (11b) hindurch emittiert,
wobei das erste Anregungslicht (15a) und das zweite Anregungslicht (17a) sich zumindest teilweise auf dem Wellenlängenumwandlungsmaterial (13) überlappen.

6. Lichtquellenvorrichtung (1) gemäß Anspruch 5, wobei
der Winkel zwischen der c-Achse (11c) und der optischen Achse des ersten Anregungslichts (15b) sich von einem Winkel zwischen der c-Achse (11c) und einer optischen Achse des zweiten Anregungslichts (17b) unterscheidet.

7. Lichtquellenvorrichtung (1) gemäß Anspruch 5 oder 6, wobei
ein Winkel zwischen der optischen Achse des ersten Anregungslichts (15b) und der optischen Achse des zweiten Anregungslichts (17b) bei einer Betrachtung aus einer Richtung senkrecht zu der zweiten Fläche (11b) 80° oder größer und 100° oder kleiner ist.

8. Lichtquellenvorrichtung (1) gemäß irgendeinem der Ansprüche 1 bis 7, ferner aufweisend:
einen dichroitischen Film, der das Anregungslicht (15a, 17a, 19a) durchlässt und wellenlängenumgewandeltes Licht, das von dem Wellenlängenumwandlungsmaterial (13) emittiert wird, reflektiert und zwischen der Saphirplatte (11) und dem Wellenlängenumwandlungsmaterial (13) bereitgestellt ist.

9. Lichtquellenvorrichtung (1) gemäß irgendeinem der Ansprüche 1 bis 8, ferner aufweisend:
einen Antireflexionsfilm, der einen Reflexionsgrad des Anregungslichts (15a, 17a, 19a) verringert und auf der zweiten Fläche (11b) der Saphirplatte (11) bereitgestellt ist.

10. Beleuchtungsvorrichtung (21), aufweisend:
die Lichtquellenvorrichtung (1) gemäß irgendeinem der Ansprüche 1 bis 9 und
ein Lichtleitelement (23).

11. Lichtquellenvorrichtung (1) gemäß Anspruch 1, wobei
die erste Fläche (11a) und die zweite Fläche (11b) der Saphirplatte (11) einen Versatzwinkel von 0,1° oder mehr von einer c-Ebene aufweisen.

12. Lichtquellenvorrichtung (1) gemäß Anspruch 2, wobei
die erste Fläche (11a) und die zweite Fläche (11b) der Saphirplatte (11) einen Versatzwinkel von 0,1° oder mehr von einer Ebene senkrecht zu einer c-Ebene haben.

## Revendications

1. Dispositif de source de lumière (1) comprenant :
une plaque de saphir (11) ayant une première surface (11a) et une seconde surface (11b) qui sont opposées l'une à l'autre ;
un matériau de conversion de longueur d'onde (13) situé à l'opposé de la première surface (11a) de la plaque de saphir (11) ; et
une première source de lumière d'excitation (15) qui émet une première lumière d'excitation (15a) ayant une directivité vers le matériau de conversion de longueur d'onde (13) à travers la seconde surface (11b),
**caractérisé en ce qu'**un angle entre la première surface (11a) et la seconde surface (11b), et un axe c (11c) du saphir est supérieur à 89° et inférieur à 91°, et
un angle entre l'axe c (11c) et un axe optique de la première lumière d'excitation (15b) est de 1° ou plus.

2. Dispositif de source de lumière (1), comprenant :
une plaque de saphir (11) ayant une première surface (11a) et une seconde surface (11b) qui sont opposées l'une à l'autre ;
un matériau de conversion de longueur d'onde (13) situé à l'opposé de la première surface (11a) de la plaque de saphir (11) ; et
une première source de lumière d'excitation (15) qui émet une première lumière d'excitation (15a) ayant une directivité vers le matériau de conversion de longueur d'onde (13) à travers la seconde surface (11b),
**caractérisé en ce qu'**un angle entre la première surface (11a) et la seconde surface (11b), et un axe c (11c) du saphir est inférieur à 1°, et
un angle entre l'axe c (11c) et un axe optique de la première lumière d'excitation (15b) est de 89° ou moins.

3. Dispositif de source de lumière (1) selon la revendication 1 ou 2, dans lequel
l'angle entre l'axe c (11c) et l'axe optique de la première lumière d'excitation (15b) est de 20° ou plus.

4. Dispositif de source de lumière (1) selon l'une quelconque des revendications 1 à 3, dans lequel
un angle d'incidence de la première lumière d'excitation (15a) par rapport à la seconde surface principale (11b) est de 75° ou moins.

5. Dispositif de source de lumière (1) selon l'une quelconque des revendications 1 à 4, comprenant en outre :
une seconde source de lumière d'excitation (17) qui émet une seconde lumière d'excitation (17a) ayant une directivité vers le matériau de conversion de longueur d'onde (13) à travers la seconde surface (11b),
dans lequel la première lumière d'excitation (15a) et la seconde lumière d'excitation (17a) se chevauchent au moins partiellement sur le matériau de conversion de longueur d'onde (13) .

6. Dispositif de source de lumière (1) selon la revendication 5, dans lequel
l'angle entre l'axe c (11c) et l'axe optique de la première lumière d'excitation (15b) est différent d'un angle entre l'axe c (11c) et un axe optique de la seconde lumière d'excitation (17b).

7. Dispositif de source de lumière (1) selon la revendication 5 ou 6, dans lequel
un angle entre l'axe optique de la première lumière d'excitation (15b) et l'axe optique de la seconde lumière d'excitation (17b) est de 80° ou plus et de 100° ou moins lorsqu'il est vu depuis une direction perpendiculaire à la seconde surface (11b).

8. Dispositif de source de lumière (1) selon l'une quelconque des revendications 1 à 7, comprenant en outre :
un film dichroïque, qui transmet la lumière d'excitation (15a, 17a, 19a) et réfléchit la lumière convertie en longueur d'onde émise par le matériau de conversion de longueur d'onde (13) et est prévu entre la plaque de saphir (11) et le matériau de conversion de longueur d'onde (13).

9. Dispositif de source de lumière (1) selon l'une quelconque des revendications 1 à 8, comprenant en outre :
un film antireflet, qui réduit une réflectance de la lumière d'excitation (15a, 17a, 19a) et est prévu sur la seconde surface (11b) de la plaque de saphir (11).

10. Dispositif d'éclairage (21) comprenant :
le dispositif de source de lumière (1) selon l'une quelconque des revendications 1 à 9 ; et
un élément de guidage de lumière (23).

11. Dispositif de source de lumière (1) selon la revendication 1, dans lequel
la première surface (11a) et la seconde surface (11b) de la plaque de saphir (11) ont un angle de décalage de 0,1° ou plus par rapport à un plan c.

12. Dispositif de source de lumière (1) selon la revendication 2, dans lequel
la première surface (11a) et la seconde surface (11b) de la plaque de saphir (11) ont un angle de décalage de 0,1° ou plus par rapport à un plan perpendiculaire à un plan c.
